Europäisches Patentamt

(19) European Patent Office

Office européen des brevets

(11) Numéro de publication : **0 218 518 B1**

(12) **FASCICULE DE BREVET EUROPEEN**

(45) Date de publication du fascicule du brevet :
02.01.91 Bulletin 91/01

(51) Int. Cl.$^5$ : **H01S 3/19, H01S 3/06**

(21) Numéro de dépôt : 86402083.9

(22) Date de dépôt : 23.09.86

(54) **Procédé de réalisation d'un laser à semiconducteur à ruban enterré avec ou sans réseau de diffraction et laser obtenu par ce procédé.**

(30) Priorité : 24.09.85 FR 8514123

(43) Date de publication de la demande :
15.04.87 Bulletin 87/16

(45) Mention de la délivrance du brevet :
02.01.91 Bulletin 91/01

(84) Etats contractants désignés :
DE GB

(56) Documents cités :
EP-A- 0 002 827
US-A- 4 468 850
ELECTRONICS LETTERS, vol. 20, no. 21, 11 octobre 1984, pages 850,851, Staines, Middlesex, GB; R. BLONDEAU et al.: "CW operation of GaInAsP buried ridge structure laser at 1.5 mum grown by LP-MOCVD"
ELECTRONICS LETTERS, vol. 20, no. 21, 11 octobre 1984, pages 856,857, Staines, Middlesex, GB; T.L. KOCH et al.: "Low-threshold high-speed 1.55 mum vapour phase transported buried heterostructure lasers (VPTBH)"
APPLIED PHYSICS LETTERS, vol. 45, no. 12, 15 décembre 1984, pages 1272-1274, American Institute of Physics, New York, US; W.T. TSANG et al.: "Heteroepitaxial ridge-overgrown distributed feedback laser at 1.5 mum"

(56) Documents cités :
ELECTRONICS LETTERS, vol. 20, no. 14, 5 juillet 1984, pages 595,596, Staines, Middlesex, GB; M. KITAMURA et al.: "Low-threshold and high-temperature single-longitudinal-mode operation of 1.55 mum-band DFB-DC-PBH-LDs"
APPLIED PHYISICS LETTERS, vol. 38, no. 5, 1er mars 1981, pages 301-303, American Institute of Physics, New York, US; P.C. CHEN et al.: "Embedded epitaxial growth of low-threshold GaInAsP/InP injection lasers"

(73) Titulaire : **Chaminant, Guy**
**64 bis rue de Paris**
**F-91570 Bievres (FR)**
Titulaire : **Charil, Josette**
**61, Avenue Victor Hugo**
**F-92140 Clamart (FR)**
Titulaire : **Bouley, Jean-Claude**
**35, Avenue du Docteur Durand**
**F-94110 Arcueil (FR)**

(72) Inventeur : **Chaminant, Guy**
**64 bis rue de Paris**
**F-91570 Bievres (FR)**
Inventeur : **Charil, Josette**
**61, Avenue Victor Hugo**
**F-92140 Clamart (FR)**
Inventeur : **Bouley, Jean-Claude**
**35, Avenue du Docteur Durand**
**F-94110 Arcueil (FR)**

(74) Mandataire : **Mongrédien, André**
**c/o BREVATOME 25, rue de Ponthieu**
**F-75008 Paris (FR)**

## Description

La présente invention a pour objet un procédé de réalisation d'un laser à semiconducteur à ruban enterré et un laser obtenu par ce procédé. Elle trouve une application générale en télécommunications optiques.

Le domaine technique de l'invention est celui des sources laser à semiconducteurs $Ga_{1-x}In_xAs_{1-y}P_y$ ou InP pour liaisons par fibre monomode. L'invention concerne plus particulièrement une structure à géométrie dite à ruban enterré, qui est une structure à faible courant de seuil. Cette structure présente des avantages intéressants par rapport aux structures de l'art antérieur. Elle permet, en premier lieu, de minimiser les courants de fuite apparaissant aux températures de fonctionnement et/ou aux puissances optiques élevées. En second lieu, elle permet un procédé de réalisation simple en deux étapes d'épitaxie au lieu de trois comme pour la plupart des structures connues.

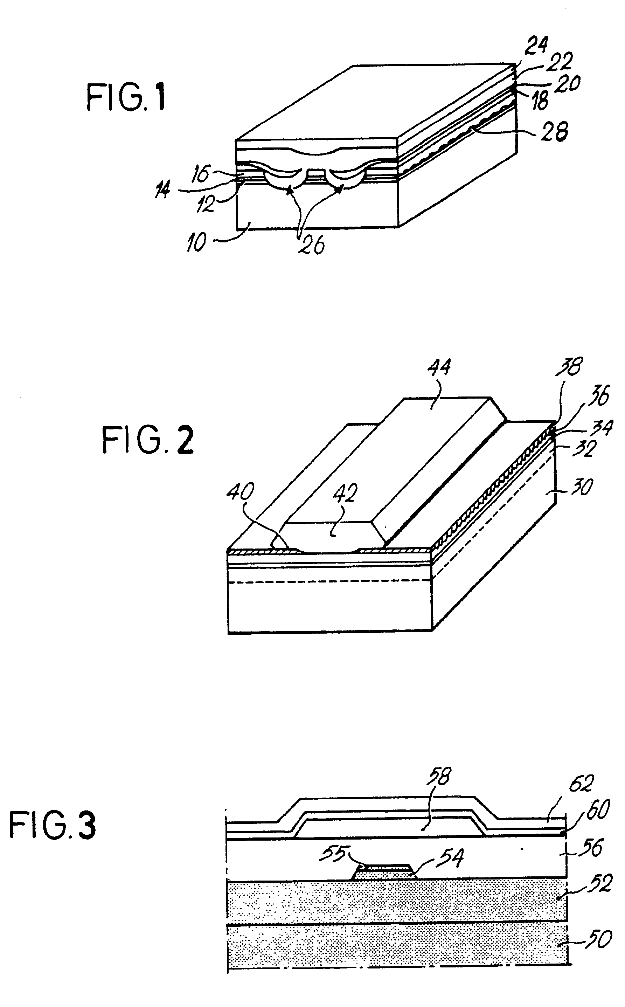

La figure 1 annexée montre une structure connue à contre-réaction distribuée et à ruban enterré. Il s'agit d'une réalisation japonaise de la NEC Corporation décrite dans un article intitulé : "Low threshold and high temperature single longitudinal mode operation of 1.55 µm - Band DFB-DC-PBH-LD's" par M. Kitamura et al publié dans Electronics Letters, 5 juillet 1984, 20-p. 596-597.

Cette structure comprend un substrat 10 en InP dopé n, une couche active 12 en InGaAsP, une couche de guidage 14 en InGaAsP, une couche de confinement 16 en InP dopé p, une couche 18 en -InP dopé p, une couche 20 en InP dopé n, une couche 22 en InP dopé p et enfin une couche de contact 24 en InGaAsP dopé p.

La structure à contre-réaction distribuée (dite DFB pour "Distributed Feed Back") comprend un réseau holographique 28 du premier ou deuxième ordre (0,24 ou 0,48 µm de pas) gravé dans le guide formé par la couche 14 située juste au-dessus de la couche active 12, laquelle fonctionne à 1,55 µm de longueur d'onde. Le confinement électronique des lignes de courant dans le ruban est obtenu à l'aide des couches de type p et n, en forme de croissants 26, situées de part et d'autre de la zone active 12 du laser.

Les meilleurs résultats à 1,3 et 1,55 µm de longueur d'onde ont été obtenus avec cette structure : courant de seuil 20 mA et puissance de 10 mW par face jusqu'à 60° C.

On notera que cette structure est élaborée en trois étapes d'épitaxie :
– la première pour déposer les deux couches quaternaires 12 et 14,
– la seconde pour la reprise d'épitaxie d'une couche 16 d'InP sur le réseau préalablement gravé dans la couche 14,
– la troisième enfin, pour l'épitaxie des couches bloquantes 20 et 22 d'InP de type n et p et celle de contact 24 en InGaAsP.

Il faut noter aussi le haut degré de précision requis pour le positionnement des couches bloquantes par rapport à la zone active.

Il faut remarquer enfin que cette structure ne peut être élaborée que par épitaxie en phase liquide.

W.T. TSANG et al des Bell Laboratories ont publié récemment un article intitulé "Heteroepitaxial ridge-overgrown distributed feedback laser at 1.5 µm" dans Appl. Phys. Lett. 45, 15 décembre 1984, 1272-1275, où il est décrit une structure dite DFB-HRO (pour "Distributed Feedback-Heteroepitaxial Ridge Overgrown") qui peut être une solution de remplacement intéressante. La structure correspondante est illustrée sur la figure 2. Elle comprend un substrat 30 en InP dopé n, une couche tampon 32 en InP dopé n, une couche active 34 en GaInAsP dopé n, une couche anti-redissolution 36 en GaInAsP dopé p dans laquelle se trouve un réseau de diffraction 38, un film 40 de diélectrique $SiO_2$ percé d'une ouverture dans laquelle a été formée une bande ("Ridge Overgrowth") 42 en InP dopé p, cette bande étant recouverte d'une métallisation.

Dans une telle structure, le ruban actif n'est pas vraiment enterré. Le confinement électrique du courant est obtenu par l'ouverture (de 5 µm de large) effectuée dans la couche de silice. Le guidage optique de la lumière engendrée dans la couche active est beaucoup moins efficace que dans la structure enterrée de la figure 1. Les courants de seuil sont de ce fait beaucoup plus importants.

On notera aussi que cette structure est élaborée en deux étapes d'épitaxie :
– la première pour le dépôt des trois couches d'InP et des couches quaternaires,
– la seconde pour la couche de confinement en InP dopé p, qui est obtenue par épitaxie localisée à travers le masque 40 de $SiO_2$ préalablement déposé sur la couche 36.

Une autre structure est connue par la publication des demandeurs intitulée : "1.55 µm strip buried Schottky laser" dans "Proceedings of the 9th IEEE International Semiconductor Laser Conference", août 7-10, 1984. Cette structure est représentée sur la figure 3. Elle comprend un substrat 50 en InP dopé n+, une couche de confinement 52 en InP dopé n, un ruban d'environ 2 µm de large formé d'une couche active 54 en GaInAsP et d'une couche de guidage 55 en GaInAsP, ce ruban étant enterré dans une couche 56 en InP dopé p ; cette couche est recouverte d'une couche 58 en GaInAs en forme de mésa d'environ 5 µm de large. L'ensemble est recouvert d'une couche de titane 60 et d'or 62.

Cette structure, dite SBH ("Strip Buried Heterostructure"), est réalisée en deux cycles d'épitaxie : le premier permet le dépôt des trois couches 52, 54, 55 respectivement en InP et en GaInAsP de composition correspondant à une longueur d'onde de 1,55 µm et en GaInAsP (à 1,3 µm), ces couches étant ensuite gravées par attaque sélective en forme de ruban. Le second cycle d'épitaxie permet de refaire croître sur le ruban la couche 56 d'InP de type p et une couche de contact 58. Le confinement du courant sur la mésa est ensuite obtenu en déposant sur le sommet un ruban de type Schottky.

La structure SBH permet de réaliser aussi un laser DFB à ruban enterré sans complication supplémentaire. Il suffit de graver en plus un réseau holographique dans la couche 55 fonctionnant à 1,3 µm, puis d'effectuer la reprise d'épitaxie en prenant soin de ne redissoudre ni le réseau ni le ruban.

Un laser DFB-SBH réalisé selon cette technique est décrit dans l'article intitulé "Laser Ga$_x$In$_{1-x}$As$_{1-y}$P$_y$ 1,55 µm à contre-réaction distribuée" par P. CORREC et al dans les Comptes-Rendus des Journées Nationales de l'Optique guidée, 20-21 mars 1985, Issy-les-Moulineaux, France.

Bien que donnant satisfaction à certains égards, toutes ces structures présentent en fait des inconvénients.

La structure à ruban type DC PBH (figure 1) appliquée aux lasers DFB, est très difficile à mettre en oeuvre surtout à cause des trois épitaxies successives et de la précision requise pour les épaisseurs et les profondeurs de gravure.

La structure type HRO-DFB (figure 2) est plus simple que la première, mais conduit, en contrepartie, à des courants de seuil plus élevés (50-100 mA au lieu de 20-40 mA) à cause du faible confinement latéral, électronique et optique.

Quant à la structure type SBH, elle donne lieu à des difficultés de réalisation si l'on veut obtenir un réseau de Bragg distribué, du fait de l'épitaxie en phase liquide qui provoque une redissolution d'une partie de la couche de guidage au cours de la reprise. On observe, par ailleurs, des courants de fuite importants dans les jonctions p-n de l'InP situées de chaque côté du ruban, et cela à partir d'un courant total de 80 mA. On obtient, de ce fait, une limitation dans la puissance d'émission du laser (3 mW à 60°C au lieu de 10 mW avec la structure DC-PBH). Des limitations du même ordre sont aussi observées dans les lasers élaborés par épitaxie MO-CVD ("Metal-Organic, Chemical Vapor Deposition").

Le but de l'invention est justement de remédier à ces inconvénients en proposant un procédé simple permettant d'obtenir une structure laser à ruban enterré par épitaxie liquide ou vapeur, avec possiblité d'obtention d'une contre-réaction distribuée, ce laser étant à faible courant de seuil et à forte puissance d'émission.

L'invention repose sur les deux points essentiels suivants :

1) – l'utilisation d'une épitaxie localisée pour enterrer le ruban actif (et éventuellement le réseau), ce qui conduit à une température de croissance plus faible qu'avec une épitaxie normale (500°C au lieu de 600°C),

2) – l'utilisation d'un substrat de type p, pour effectuer la reprise d'épitaxie, ce qui permet de n'utiliser qu'une seule couche d'InP très fortement dopé n$^+$ (5.10$^{18}$ cm$^{-3}$) pour limiter efficacement les courants de fuite dans les jonctions p-n latérales.

Il est connu que l'épitaxie localisée d'un ruban de quelques µm de large conduit à une vitesse de croissance beaucoup plus importante que dans le cas d'une épitaxie sur toute la surface d'un substrat. L'excès de solution dans le bain précipite sur des régions de faibles dimensions. Ce phénomène est signalé dans l'article intitulé "Embedded epitaxial growth of low-threshold GaInAsP/InP injection laser" par P.C. CHEN et al publié dans Appl. Phys. Lett. 38 (5) 1er mars 1981, pp. 301-303.

Ce phénomène traduit un très fort degré de sursaturation du bain et, par conséquent, permet d'effectuer les épitaxies à basse température. Des croissances à 500°C ont été ainsi réalisées au lieu de 600-630°C dans le cas usuel.

Cette diminution de la température de croissance permet :

– d'une part, d'éviter les problèmes de redissolution de la couche de guidage mentionnés ci-dessus,

– de limiter, d'autre part, les déformations et détériorations du réseau de diffraction, couramment observées aux températures élevées.

L'utilisation d'un substrat de type p, à la place d'un substrat de type n, dans la structure SBH, conduit en outre à ne réépitaxier qu'une seule couche d'InP fortement dopé n$^+$ pour enterrer le ruban. Une couche de contact est dans ce cas superflue compte tenu des faibles valeurs de résistance de contact mesurées sur les couches d'InP-n$^+$. Par ailleurs, il est très important de noter qu'une couche très conductrice conduit à une réduction importante des courants de fuite dans les jonctions p-n latérales. En effet, dans la structure SBH classique, une saturation importante de la puissance émise apparaît pour un courant de 80 mA ; au-delà, le courant passe dans les homojonctions latérales. On peut montrer que le courant de saturation I$_{sat}$ est relié à la différence de potentiel interne de l'homojonction, soit V$_h$, et de l'hétérojonction, soit V$_H$, par la relation :

$$I_{sat} = \frac{V_h - V_H}{R_{eq}}$$

où R$_{eq}$ est la résistance entre le contact et le ruban enterré. Les valeurs expérimentales de V$_h$-V$_H$ sont de l'ordre de 400 mV, celles de R$_{eq}$ calculées à partir du dopage et de l'épaisseur de la couche InP-p de l'ordre de 5 Ω, ce qui conduit à des valeurs calculées de I$_{sat}$ voisines des valeurs expérimentales.

L'utilisation d'une couche de type n+ conduit ainsi, compte tenu de la forte mobilité des électrons, à une résistance $R_{eq}$ au moins 10 fois plus faible et, par conséquent, à un courant de saturation 10 fois plus fort.

De façon précise, l'invention a pour objet un procédé de réalisation d'un laser à semiconducteur à ruban enterré selon la revendication 1.

De toute façon, les caractéristiques de l'invention apparaîtront mieux à la lumière de la description d'un mode de réalisation. Cette description se réfère à des dessins annexés sur lesquels :

- la figure 1, déjà décrite, représente un laser DC-PBH de l'art antérieur,
- la figure 2, déjà décrite, représente un laser HRO de l'art antérieur,
- la figure 3, déjà décrite, représente un laser SBH de l'art antérieur,
- la figure 4 représente un exemple de réalisation d'un laser selon l'invention.

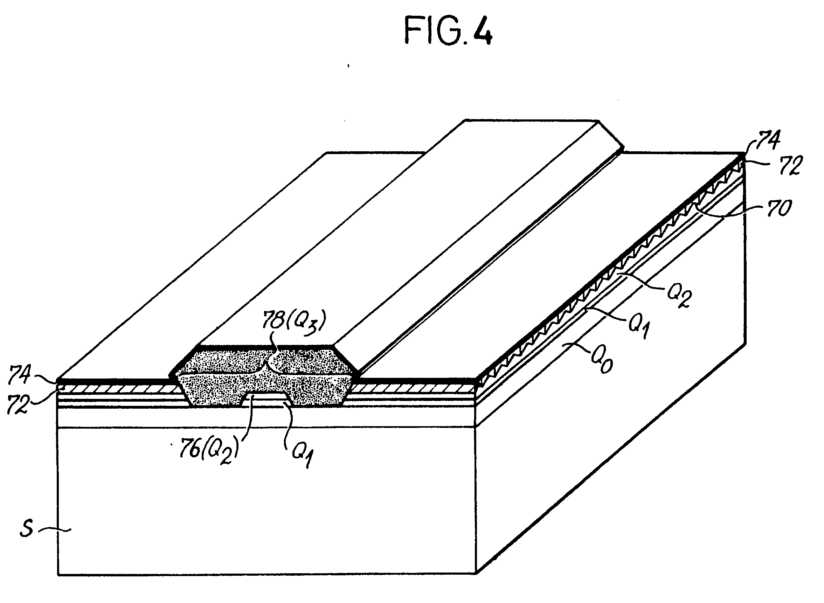

La structure illustrée à la figure 4 nécessite deux épitaxies. Dans la première, trois couches sont déposées sur un substrat S en InP de type p+ :

- une couche $Q_0$ d'InP de type p dopée entre $5.10^{16}$ et $3.10^{17}$ cm$^{-3}$,
- une couche active $Q_1$ en GaInAsP de composition correspondant à une longueur d'onde d'émission de 1,55 μm ou 1,3 μm,
- une couche de guidage $Q_2$ en GaInAsP de composition correspondant d'une longueur d'onde 1,3 μm pour un laser émettant à 1,5 μm ou 1,15 μm pour un laser émettant à 1,3 μm.

Dans le cas d'un laser DFB à 1,3 ou 1,55 μm, un réseau de diffraction 70 du premier ou du deuxième ordre est ensuite gravé par les techniques habituelles dans la couche de guidage $Q_2$.

On dépose ensuite une couche 72 de diélectrique, en SiO$_2$ de préférence ou, éventuellement, en Si$_3$N$_4$, de 0,15 μm-0,17 μm d'épaisseur. Le dépôt s'effectue par CVD assisté par plasma sur toute la surface du réseau.

Deux ouvertures en forme de bandes placées côte à côte sont ensuite gravées dans la silice à l'aide d'un même masque.

La gravure de la structure est ensuite effectuée par attaque chimique pour creuser sélectivement les deux couches $Q_1$ et $Q_2$ jusqu'à la couche $Q_0$ en InP dopé p. On délimite ainsi, dans les deux couches quaternaires, un ruban 76 de largeur $W_1$ égale à 1 ou 2 μm, au centre d'une ouverture 78 de largeur $W_2$ dont la valeur peut être comprise entre 8 et 20 μm.

On retire ensuite le masque de diélectrique qui subsistait au sommet du ruban 76 et l'on effectue une seconde épitaxie d'une couche InP de type n dopé entre $10^{18}$ et $5.10^{18}$ cm$^{-3}$. La reprise d'épitaxie est effectuée à basse température pour les raisons évoquées ci-dessus.

Il est évident que ce procédé et la structure obtenue par ce procédé peuvent aussi convenir à des lasers sans contre-réaction distribuée, c'est-à-dire à des lasers à 1,3 ou à 1,55 μm, à faible courant de seuil (10-20 mA).

**Revendications**

1. Procédé de réalisation d'un laser à semi-conducteur à ruban enterré comprenant les opérations suivantes :
   - on forme une hétérostructure par une première épitaxie à une première température, cette épitaxie consistant à déposer sur un substrat (S) en un premier matériau semi-conducteur dopé p+, une couche de confinement ($Q_0$) en ledit premier matériau dopé p, une couche active ($Q_1$) en un second matériau semi-conducteur et une couche de guidage ($Q_2$) en ledit second matériau semi-conducteur,
   - on dépose sur la couche de guidage ($Q_2$) une couche de diélectrique (72),
   - on forme dans la couche de diélectrique (72) deux ouvertures parallèles et allongées de part et d'autre de la zone où l'on veut obtenir le ruban,
   - on grave la couche active ($Q_1$) et la couche de guidage ($Q_2$) jusqu'à la couche de confinement ($Q_0$), ce qui laisse subsister un ruban (76),
   - on enlève la couche diélectrique (72) au-dessus du ruban (76) mais on le maintient sur le reste de la structure de chaque côté des ouvertures (78),
   - on effectue une reprise d'épitaxie dans les deux zones allongées ainsi gravées à une seconde température inférieure à la première température à laquelle a été effectuée la première épitaxie, cette reprise d'épitaxie était destinée à enterrer le ruban dans une couche ($Q_3$) en ledit premier matériau semi-conducteur dopé n+.

2. Procédé selon la revendication 1, caractérisé par le fait que l'on grave en outre la couche de guidage ($Q_2$) pour constituer un réseau de diffraction distribué (70).

3. Procédé selon la revendication 1, caractérisé par le fait que le substrat (S) est en InP dopé p+, la couche de confinement ($Q_0$) en InP dopé p entre $5.10^{16}$ et $3.10^{17}$cm$^{-3}$, la couche active ($Q_1$) en GaInAsP et la couche de guidage ($Q_2$) en GaInAsP, la couche de reprise d'épitaxie en InP dopé n+ entre $10^{18}$ et $5.10^{18}$cm$^{-3}$.

4. Procédé selon la revendication 1, caractérisé par le fait que la reprise d'épitaxie s'effectue à une température inférieure à 600°C.

5. Procédé selon la revendication 4, caractérisé par le fait que la reprise d'épitaxie s'effectue vers 500°C.

6. Procédé selon la revendication 1, caractérisé par le fait que la reprise d'épitaxie s'effectue en phase liquide.

## Ansprüche

1. Verfahren zur Herstellung eines Halbleiterlasers mit vergrabenem Streifen mit folgenden Verfahrensschritten :

– man bildet eine Heterostruktur durch eine erste Epitaxie bei einer ersten Temperatur, wobei die Epitaxie darin besteht, daß man auf einem Substrat (S) aus einem ersten, p+-dotierten Halbleitermaterial eine Einschließungsschicht ($Q_0$) aus diesem ersten p-dotierten Material, eine aktive Schicht ($Q_1$) aus einem zweiten halbleitenden Material und eine Führungsschicht ($Q_2$) aus dem zweiten halbleitenden Material abscheidet,

– man scheidet auf der Führungsschicht ($Q_2$) eine dielektrische Schicht (72) ab,

– man bildet in der dielektrischen Schicht (72) zwei parallele, längliche Öffnungen auf der einen und der anderen Seite der Zone, wo man den Streifen erhalten möchte,

– man ätzt die aktive Schicht ($Q_1$) und die Führungsschicht ($Q_2$), bis zur Einschließungsschicht ($Q_0$), was einen Streifen (76) übrigläßt,

– man entfernt die dielektrische Schicht (72) über dem Streifen (76), beläßt sie jedoch auf dem Rest der Struktur auf jeder Seite der Öffnungen (78),

– man führt eine Wiederholung der Epitaxie in den beiden länglichen, derart geätzten Zonen bei einer zweiten Temperatur durch, die niedriger ist als die erste Temperatur, bei der die erste Epitaxie durchgeführt wurde, wobei diese Wiederholung der Epitaxie dazu bestimmt ist, den Streifen unter einer Schicht ($Q_3$) aus dem ersten halbleitenden, n+-dotierten Material zu vergraben.

2. Verfahren nach Anspruch 1, gekennzeichnet durch die Tatsache, daß man außerdem die Führungsschicht ($Q_2$) ätzt, um ein verteiltes Beugungsnetzwerk (70) zu bilden.

3. Verfahren nach Anspruch 1, gekennzeichnet durch die Tatsache, daß das Substrat (S) aus p+-dotiertem InP, die Einschließungsschicht ($Q_0$) aus zwischen $5.10^{16}$ und $3.10^{17} cm^{-3}$ p-dotiertem InP, die aktive Schicht ($Q_1$) aus GaInAsP und die Führungsschicht ($Q_2$) aus GaInAsP besteht, wobei die Epitaxiewiederholungsschicht aus zwischen $10^{18}$ und $5.10^{18} cm^{-3}$ n+-dotiertem InP besteht.

4. Verfahren nach Anspruch 1, gekennzeichnet durch die Tatsache, daß man die Epitaxiewiederholung bei einer Temperatur unter 600°C durführt.

5. Verfahren nach Anspruch 4, gekennzeichnet durch die Tatsache, daß man die Epitaxiewiederholung bei einer Temperatur von etwa 500°C durchführt.

6. Verfahren nach Anspruch 1, gekennzeichnet durch die Tatsache, daß man die Epitaxiewiederholung in der flüssigen Phase durchführt.

## Claims

1. Process for producing a buried strip semiconductor laser comprising the following operations :

a heterostructure is formed by a first epitaxy at a first temperature, said epitaxy consisting of depositing on a substrate (S) of a first doped p+ semiconductor material a confinement layer ($Q_0$) of p-doped first material, an active layer ($Q_1$) of a second semiconductor material and a guide layer ($Q_2$) of the second semiconductor material,

a dielectric layer (72) is deposited on the guide layer ($Q_2$),

in the dielectric layer (72) are formed two elongated, parallel openings on either side of the zone where it is wished to obtain the strip,

the active layer ($Q_1$) and the guide layer ($Q_2$) are etched to the confinement layer ($Q_0$), which leaves behind a strip (76),

the dielectric layer (72) is removed above the strip (76), but is maintained over the remainder of the structure on each side of the opening (78),

epitaxy is repeated in the two elongated zones etched in this way at a second temperature below the first temperature at which the first epitaxy was performed, said repeated epitaxy being intended to bury the strip in a layer (Q3) of said first n+ doped semiconductor material.

2. Process according to claim 1, characterized in that the guide layer ($Q_2$) is also etched in order to form a distributed diffractive network (70).

3. Process according to claim 1, characterized in that the substrate (S) is of p+ doped InP, the confinement layer ($Q_0$) of p doped InP between $5.10^{16}$ and $3.10^{17} cm^{-3}$, the active layer ($Q_1$) of GaInAsP and the guide layer ($Q_2$) of GaInAsP, the epitaxy repeat layer of InP being n+ doped between $10^{18}$ and $5.10^{18} cm^{-3}$.

4. Process according to claim 1, characterized in that the epitaxy repeat is carried out at a temperature below 600°C.

5. Process according to claim 4, characterized in that the epitaxy repeat is carried out at approximately 500°C.

6. Process according to claim 1, characterized in that the epitaxy repeat is carried out in the liquid phase.

FIG.1

FIG.2

FIG.3

# FIG.4

EP 0 218 518 B1